# EUROPEAN PATENT APPLICATION

(11) **EP 2 477 070 A1**
(43) Date of publication of application: **18.07.2012**
(21) Application number: 12151191.9
(22) Date of filing: 16.01.2012
(51) Int. Cl.: G03B 21/20, G03B 33/06, G03B 33/12, H04N 9/31, G03B 21/16, H01S 5/00

(54) **Image projection device using laser light sources**

(30) Priority: 18.01.2011 JP 2011008137; 18.01.2011 JP 2011008140; 18.01.2011 JP 2011008142
(71) Applicant: Panasonic Corporation, Kadoma-shi Osaka 571-8501 (JP)
(72) Inventor: Enomoto, Hirofumi, Osaka, 540-6207 (JP); Mizushima, Tetsuro, Osaka, 540-6207 (JP); Nakayama, Kenji, Osaka, 540-6207 (JP); Hatase, Yuichi, Osaka, 540-6207 (JP); Kitaoka, Yoshitaka, Osaka, 540-6207 (JP)
(74) Representative: Eisenführ, Speiser & Partner

(57) **Abstract**

An image display apparatus (1) having a case supporting laser light source apparatuses emitting laser light of green color (2), red color (3), and blue color (4), a projection optical system (8). The case includes: a front wall (23) to which the blue color laser light source apparatus (4) is mounted and a projection outlet (8a) of the projection optical system is provided; and a side wall (24) that is connected to the front wall and to which the red color laser light source apparatus (3) and the green color laser light source apparatus (2) are mounted. The image display apparatus further includes dichroic mirrors (14,15) guiding the laser light of respective colors to the projection optical system side. Either of the dichroic mirrors reflects laser light having a wavelength shorter than or equal to the wavelength of the green color laser light. A cooler (91,92) that cools the laser light source apparatuses is provided on the side wall side.

## Description

### CROSS-REFERENCE TO RELATED APPLICATIONS

The present application claims priority under 35 U.S.C. §119 of Japanese Applications Nos. 2011-008140, 2011-008137, and 2011-008142, all of which were filed on January 18, 2011, the disclosures of which are expressly incorporated by reference herein in their entireties.

### BACKGROUND OF THE INVENTION

### 1. Field of the Invention

The present invention relates to an image display apparatus in which a laser light source apparatus employing a semiconductor laser is incorporated.

### 2. Description of Related Art

In recent years, technology employing semiconductor lasers as a light source of an image display apparatus has drawn attention. Compared with a mercury lamp conventionally used for an image display apparatus, the semiconductor laser has advantages including good color reproducibility, instant light up, long life, high efficiency reducing power consumption, easy miniaturization, and the like.

As a conventional image display apparatus employing the semiconductor laser, a projector is known as described in Japanese Patent Application Publication No. 2010-32796, for example. In such a projector, three laser light source apparatuses having semiconductor lasers emit laser light of three colors (red color, blue color, and green color), and projects the laser light onto an external screen as image light.

The above-described three laser light source apparatuses each have different temperature characteristics. Basically, an increase in temperature of a laser light source apparatus causes a decrease in its output. However, in the conventional technology described in the above patent literature 1, the laser light source apparatus is not effectively cooled. Therefore, a circumstance arises where the quality of a projected image deteriorates as temperature of the laser light source apparatus is increased by a long period of use. In terms of cooling of the laser light source apparatuses, compared with laser light source apparatuses of the other two colors, the output of a red color laser light source apparatus is significantly decreased by the temperature increase. Thus, cooling of the red color laser light source apparatus is especially critical. In addition, it is desirable that the laser light source apparatus be appropriately cooled without increasing the size of the image display apparatus.

Further, in the conventional technology described in patent literature 1, the three laser light source apparatuses are placed so as to emit light of red color, blue color, and green color, respectively, in the same direction. Thus, a large number of optical elements are required to be present on optical paths in order to guide laser light of the respective colors to a projection optical system on a projection side. As a result, it is difficult to provide a smaller and lighter apparatus.

Furthermore, the conventional image display apparatus described in patent literature 1 employs infrared laser light to generate green color laser light. Thus, there is a case where a small amount of infrared rays is emitted from the green color laser light source apparatus. The conventional image display apparatus, however, is designed without considering such a circumstance. Therefore, when the infrared rays are externally projected from the image display apparatus and enter a user's eye, it causes quite a burden to the user.

### SUMMARY OF THE INVENTION

The advantage of the present invention is to provide an image display apparatus having a simple configuration and being capable of guiding laser light of each color to a projection optical system side using a smaller number of optical elements than that of laser light source apparatuses.

In order to obtain the advantage, an image display apparatus of the present invention includes: a first laser light source apparatus emitting a first color laser light; a second laser light source apparatus emitting a second color laser light having a wavelength different from a wavelength of the first color laser light; a third laser light source apparatus emitting a third color laser light having a wavelength between the wavelength of the first color laser light and the wavelength of the second color laser light; a projection optical system externally projecting the laser light of the respective colors; and a case supporting the laser light source apparatuses of the respective colors and the projection optical system. The case includes a front wall and a side wall that is connected to the front wall. On the front wall, the laser light source apparatus emitting either of the first or the second color laser light is mounted and a projection outlet of the projection optical system is provided. On the side wall, the laser light source apparatus emitting the other of the first or the second color laser light and the laser light source apparatus emitting the third color laser light are mounted.

The image display apparatus further includes: first and second optical elements reflecting at least one of the three laser lights based on the wavelength of the one of the three laser lights and transmitting at least one of the remaining laser lights based on the wavelength of the one of the remaining laser lights, and guiding the laser light to the projection optical system side. An emission optical axis of the second color laser light sequentially intersects with an emission optical axis of the third color laser light and an emission optical axis of the first color laser light. The first optical element transmits the second color laser light and reflects the third color laser light toward the second optical element, the first optical element being at a position where the emission optical axis of the second laser light and the emission optical axis of the third color laser light intersect. The second optical element reflects either one of both the second and third color laser lights and the first color laser light and transmits the other laser light, the second optical element being at a position where the emission optical axis of the second color laser light and the emission optical axis of the first color laser light intersect, and the second color laser light having been transmitted by the first optical element and the third color laser light having been reflected by the first optical element. The emission optical axis of the first color laser light is parallel to the emission optical axis of the third color laser light. The emission optical axis of the second color laser light sequentially and orthogonally intersects with the emission optical axis of the first color laser light and the emission optical axis of the third color laser light.

Accordingly, in an image display apparatus using three primary colors, it is possible to guide the laser light of the respective colors to the projection optical system side employing a smaller number of the optical elements than that of the laser light source apparatuses while having a simple arrangement of the laser light source apparatuses.

Another advantage of the present invention is to provide an image display apparatus having a simple configuration and being capable of preventing infrared rays from being externally projected, the infrared rays being possibly emitted from the green color laser light source apparatus.

In order to obtain the advantage, in the image display apparatus of the present invention, the first color laser light is either one of the red color laser light and the blue color laser light, the second color laser light is the other one of the red color laser light and the blue color laser light, and the third color laser light is the green color laser light.

The third color laser light is the green color laser light obtained by converting a wavelength of infrared laser light.

The image display apparatus further includes: first and second optical elements reflecting at least one of the three laser lights based on the wavelength of the one of the three laser lights and transmitting at least one of the remaining laser lights based on the wavelength of the one of the remaining laser lights, and guiding the laser light to the projection optical system side. The second optical element reflects, to the projection optical system side, the third color laser light and the second color laser light having wavelengths within a green color wavelength range or shorter; transmits the first color laser light to the projection optical system side; and transmits the infrared laser light to a direction which is not the projection optical system side, the second optical element being at a position where the emission optical axis of the laser light emitting the first color laser light and the emission optical axis of the laser light emitting the second color laser light intersect. The "direction which is not the projection optical system side" herein means a direction different from the direction in which the second optical element transmits the first color laser light. More specifically, it is desirable that the direction orthogonally intersect with the direction in which the second optical element transmits the first color laser light.

Alternatively, the first optical element reflects, to the projection optical system side, the third color laser light having a wavelength within a green color wavelength range or shorter; transmits the second color laser light to the projection optical system side; and transmits the infrared laser light to a direction which is not the projection optical system side, the first optical element being at a position where the emission optical axis of the laser light emitting the second color laser light and the emission optical axis of the laser light emitting the third color laser light intersect. The "direction except the projection optical system side" herein means a direction different from the direction in which the first optical element transmits the second color laser light. It is further desirable that the direction orthogonally intersect with the direction in which the first optical element transmits the second color laser light.

Accordingly, either one of the first and second optical elements guiding the laser light to the projection optical system side has spectral characteristics that reflect the laser light having a wavelength shorter than or equal to the wavelength of the green color laser light and also transmit the laser light having a wavelength longer than the wavelength of the green color laser light. Thus, it is possible for the image display apparatus employing three primary colors and having a simple configuration to prevent the infrared rays from being externally projected, the infrared rays being possibly emitted from the green color laser light source apparatus.

Furthermore, another advantage of the present invention is to provide an image display apparatus having a simple configuration and being capable of efficiently cooling the laser light source apparatus having most inferior temperature characteristics, thereby inhibiting image quality from being deteriorated by temperature increase in a laser light source apparatus.

In order to obtain the advantage, the projection outlet of the image display apparatus of the present invention is provided to the front wall at an end that is not connected to the side wall. The laser light source apparatus emitting the first color laser light is provided to the side wall at an end that is not connected to the front wall.

The image display apparatus of the present invention further includes: a cooler that is provided outside the case and cools the laser light source apparatuses of the respective colors. The cooler is provided on the side wall side.

The side wall has a projection which protrudes in a direction extended from an end of the front wall and to which the laser light source apparatus emitting the third color laser light is mounted.

The cooler is provided outside the laser light source apparatus emitting the first color laser light. Alternatively, the cooler is provided on the side wall side in a vicinity of the laser light source apparatus emitting the first color laser light.

In the above described configurations, it is desirable that the laser light source apparatus emitting the first color laser light be either one of the red color laser light source apparatus emitting the red color laser light and the blue color laser light source apparatus emitting the blue color laser light. It is also desirable that the laser light source apparatus emitting the second color laser light be the other one of the red color laser light source apparatus emitting the red color laser light and the blue color laser light source apparatus emitting the blue color laser light. It is particularly desirable that the laser light source apparatus emitting the first color laser light be the red color laser light source apparatus emitting the red color laser light. In addition, it is desirable that the laser light source apparatus emitting the third color laser light emit the green color laser light by converting the wavelength of the infrared laser light.

With these configurations, it is possible to effectively utilize an open space in the apparatus and to downsize the apparatus. In addition, despite the simple and compact configuration, it is possible to effectively cool the first color laser light source apparatus having most inferior temperature characteristics, thereby preventing image quality from being deteriorated by temperature increase in the laser light source apparatus. Furthermore, even when the cooler is provided in the vicinity of the first color laser light source apparatus, projection of the image light from the projection outlet is not disturbed, and thus it is possible to prevent the apparatus from increasing in size.

### BRIEF DESCRIPTION OF THE DRAWINGS

The present invention is further described in the detailed description which follows, in reference to the noted plurality of drawings by way of non-limiting examples of exemplary embodiments of the present invention, in which like reference numerals represent similar parts throughout the several views of the drawings, and wherein:
Fig. 1 is a perspective view of a laptop type information processing apparatus 101 incorporating an image display apparatus 1;
Fig. 2 illustrates a configuration of main components of an optical engine unit 1a;
Fig. 3 is a perspective view illustrating the main components of the optical engine unit 1a;
Fig. 4 is a schematic view illustrating a state of green color laser light in a green color laser light source apparatus 2;
Figs. 5A and 5B are perspective views of the image display apparatus 1;
Fig. 6 is a perspective view illustrating an interior of a housing case 51 of the image display apparatus 1;
Fig. 7 is a plan view illustrating an interior of a housing of the optical engine unit 1a;
Fig. 8 is a schematic view illustrating optical paths of laser light of each color in an image display apparatus 1 according to a second embodiment;
Fig. 9 is a chart illustrating spectral characteristics of a dichroic mirror 14 according to the second embodiment;
Figs. 10 is a chart illustrating spectral characteristics of a dichroic mirror 15 according to the second embodiment; and
Fig. 11 is a schematic view illustrating optical paths of laser light of each color in an image display apparatus 1 according to a third embodiment.

### DETAILED DESCRIPTION OF PREFERRED EMBODIMENTS

The particulars shown herein are by way of example and for purposes of illustrative discussion of the embodiments of the present invention only and are presented in the cause of providing what is believed to be the most useful and readily understood description of the principles and conceptual aspects of the present invention. In this regard, no attempt is made to show structural details of the present invention in more detail than is necessary for the fundamental understanding of the present invention, the description is taken with the drawings making apparent to those skilled in the art how the forms of the present invention may be embodied in practice.

Hereinafter, embodiments of the present invention will be explained with reference to the drawings.

### [First embodiment]

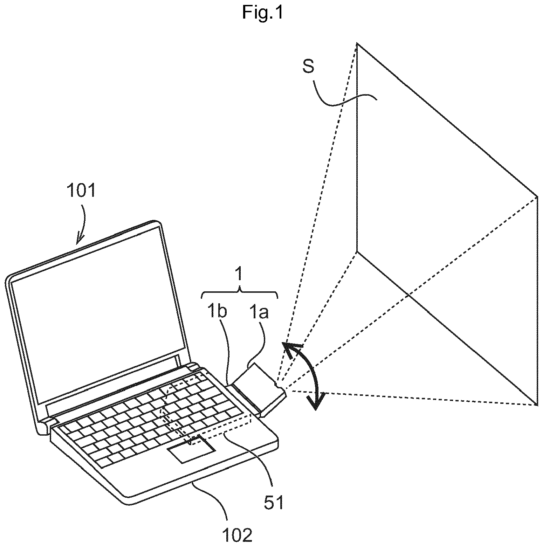

Fig. 1 is a perspective view of a laptop type information processing apparatus 101 incorporating an image display apparatus 1 according to the present invention. In the information processing apparatus 101, a housing space is provided on a rear side of a keyboard of a main body 102 in order to store the image display apparatus 1. The image display apparatus 1 can be freely ejected from or inserted to the housing space. Similar to a known DVD (Digital Versatile Disc) drive, the image display apparatus 1 is stored in the housing space when not in use and is pulled out from the housing space when in use. An optical engine unit 1a of the image display apparatus 1 is rotatably supported by a control unit 1b. A user can project laser light from the image display apparatus 1 on a screen S by rotating the optical engine unit 1a to a predetermined angle.

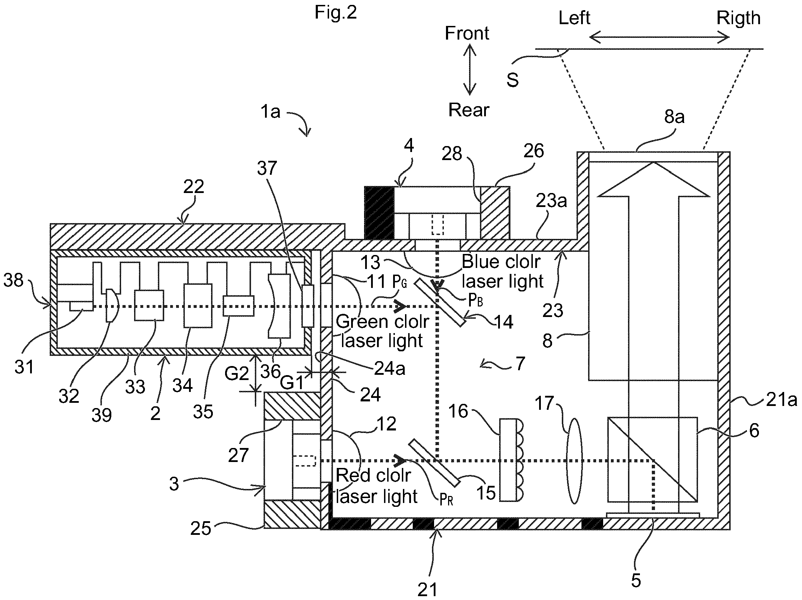

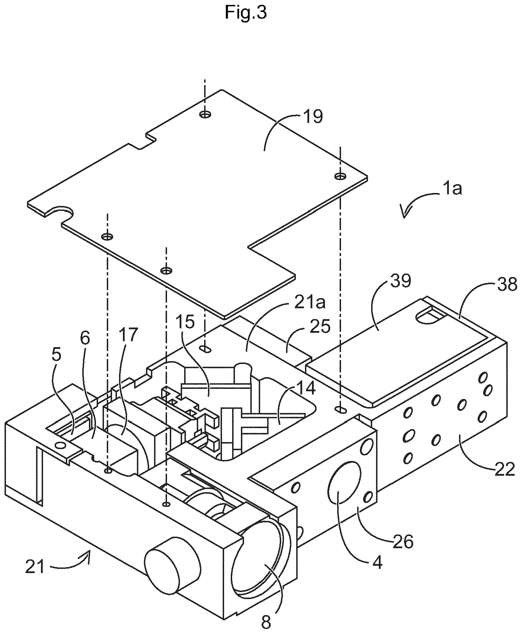

Fig. 2 illustrates a configuration of main components of the optical engine unit 1a. Fig. 3 is a perspective view illustrating the main components of the optical engine unit 1a. The optical engine unit 1a enlarges and projects a predetermined image to display it on the screen S. The optical engine unit 1a includes a green color laser light source apparatus 2 emitting green color laser light; a red color laser light source apparatus 3 emitting red color laser light; a blue color laser light source apparatus 4 emitting blue color laser light; a liquid crystal reflective type spatial light modulator 5 spatially modulating the laser light emitted from each of the laser light source apparatuses 2 to 4 according to image signals, and forming an image; a polarization beam splitter 6 reflecting the laser light emitted from each of the laser light source apparatuses 2 to 4 and radiating the light onto the spatial light modulator 5, and transmitting the modulated laser light emitted from the spatial light modulator 5; a relay optical system 7 guiding the laser light emitted from each of the laser light source apparatuses 2 to 4 to the polarization beam splitter 6; and a projection optical system 8, including a projection lens, projecting on the external screen S the modulated laser light that has been transmitted through the polarization beam splitter 6.

The image display apparatus 1 displays a color image in a field sequential system (time divisional display system). Laser light of each color is sequentially emitted from the respective laser light source apparatus 2 to 4 on a time division basis. Images of the laser light having respective colors are recognized as a color image due to a residual image effect.

The relay optical system 7 includes collimator lenses 11 to 13; a first dichroic mirror 14 and a second dichroic mirror 15; a diffuser panel 16; and a field lens 17. The collimator lenses 11 to 13 convert the laser light having respective colors into a parallel beam, the laser light being emitted from the laser light source apparatuses 2 to 4, respectively. The first dichroic mirror 14 and the second dichroic mirror 15 guide the laser light having respective colors in a predetermined direction, the laser light having passed through the collimator lenses 11 to 13. The diffuser panel 16 diffuses the laser light guided by the dichroic mirrors 14 and 15. The field lens 17 converts the laser light having passed through the diffuser panel 16 into a converging laser.

When a side on which the laser light is emitted from a projection outlet 8a of the projection optical system 8 toward the screen S is a front side, the blue color laser light is emitted rearward from the blue color laser light source apparatus 4. The green color laser light is emitted from the green color laser light source apparatus 2 and the red color laser light is emitted from the red color laser light source apparatus 3, such that an optical axis of the green color laser light and an optical axis of the red color laser light orthogonally intersect with an optical axis of the blue color laser light. The blue color laser light, the red color laser light, and the green color laser light are guided to the same optical path by the two dichroic mirrors 14 and 15. Specifically, the blue color laser light and the green color laser light are guided to the same optical path by the first dichroic mirror 14; and the blue color laser light, the green color laser light, and the red color laser light are guided to the same optical path by the second dichroic mirror 15.

Each of the first dichroic mirror 14 and the second dichroic mirror 15 is provided with a film on a surface thereof to transmit and reflect laser light having a predetermined wavelength. The first dichroic mirror 14 transmits the blue color laser light and reflects the green color laser light. The second dichroic mirror 15 transmits the red color laser light and reflects the blue color laser light and the green color laser light.

The optical members above are supported by a case 21. The case 21 acts as a heat dissipater dissipating heat generated at the laser light source apparatuses 2 to 4. The case 21 is formed of a highly thermally conductive material, such as aluminum or copper. Inside the case 21, the spatial light modulator 5, the polarization beam splitter 6, the relay optical system 7, the projection optical system 8, and the like are mounted. An upper opening of the case 21 is sealed by a metal cover 19 in order to prevent the laser light from leaking to the exterior from other than the projection optical system 8.

The green color laser light source apparatus 2 is mounted to a mounting plate (projection) 22, which is provided to the case 21 in a state protruding to a side from the main body 21a of the case 21. The mounting plate 22 is provided protruding orthogonal to a side wall 24 so as to extend a front wall 23 from a corner at which the front wall 23 and the side wall 24 orthogonally intersect, the front wall 23 being positioned in the front of a housing space of the relay optical system 7, and the side wall 24 being positioned on the side of the housing space. With this configuration, the mounting plate 22 acts as a heat sink that facilitates dissipation of heat from the green color light source apparatus 2. In addition, the heat of the green color light source apparatus 2 becomes less likely to be transferred to the case 21, thereby preventing the heat from affecting the laser light source apparatuses of the other two colors. The mounting plate 22 may be provided as a member separate from the main body 21a. When the mounting plate 22 is provided as a single body with the main body 21a as in the present embodiment, however, the heat dissipation effect is increased. The red color laser light source apparatus 3 is mounted on an external surface 24a of the side wall 24 in a state being held by a holder 25. The blue color laser light source apparatus 4 is mounted on an external surface 23a of the front wall 23 in a state being held by a holder 26. A theoretical plane including the external surface 24a and a theoretical plane including the external surface 23a mutually orthogonally intersect. In addition, the green color laser light source apparatus 2 may be mounted on the external surface 24a of the side wall 24, in a similar manner as the red color laser light source apparatus 3.

In the case 21, the projection outlet 8a of the projection optical system 8 is provided to the side wall 24 at a right end thereof. The right end of the side wall 24 is provided projecting forward. The blue color laser light source apparatus 4 is mounted in an open space situated to the left of the projection. Thereby, the optical engine unit 1a can be downsized.

The red color laser light source apparatus 3 and the blue color laser light source apparatus 4 are provided in a CAN package, in which a laser chip emitting laser light is disposed such that an optical axis is positioned on a central axis of a can-shaped external portion in a state where the laser chip is supported by a stem. The laser light is emitted through a glass window provided to an opening of the external portion. The red color laser light source apparatus 3 and the blue color laser light source apparatus 4 are, for example, press-fitted into attachment holes 27 and 28, respectively, which are provided to the holders 25 and 26, respectively. The red color laser light source apparatus 3 and the blue color laser light source apparatus 4 are thus fixed to the holders 25 and 26, respectively. Heat generated by the laser chips of the red color laser light source apparatus 3 and the blue color laser light source apparatus 4 is transferred through the holders 25 and 26, respectively, to the case 21 and dissipated. The holders 25 and 26 are formed of a highly thermally conductive material, such as aluminum and copper.

The red color laser light has a wavelength of 640 nm. As long as laser light is recognized as having a red color, any laser light having a wavelength range with a peak wavelength between 610 nm and 750 nm, for example, may be used. The blue color laser light has a wavelength of 450 nm. As long as laser light is recognized as having a blue color, any laser light having a wavelength range with a peak wavelength between 435 nm and 480 nm, for example, may be used.

As shown in Fig. 2, the green color laser light source apparatus 2 includes a semiconductor laser 31; an FAC (Fast-Axis Collimator) lens 32; a rod lens 33; a laser medium 34; a wavelength conversion element 35; a concave mirror 36; a glass cover 37; a base 38 supporting the components; and a cover 39 covering the components. The semiconductor laser 31 emits excitation laser light. The FAC lens 32 and the rod lens 33 are collecting lenses that collect the excitation laser light emitted from the semiconductor laser 31. The laser medium 34 is excited by the excitation laser light and emits fundamental laser light (infrared laser light). The wavelength conversion element 35 converts a wavelength of the fundamental laser light and emits half wavelength laser light (green color laser light). The concave mirror 36 constitutes a resonator with the laser medium 34. The glass cover 37 prevents leakage of the excitation laser light and the fundamental wavelength laser light.

As shown in Fig. 2, a space G1 having a predetermined width (0.5 mm or less, for example) is provided between the green color laser light source apparatus 2 and the side wall 24 of the case 21. Thereby, the heat of the green color laser light source apparatus 2 becomes less likely to be transferred to the red color laser light source apparatus 3. An increase in temperature of the red color laser light source apparatus 3 is then inhibited. The red color laser light source apparatus 3, which has undesirable temperature characteristics, can thus be stably operated. In addition, with the space G1 being 0.5 mm or less, a decrease in the use efficiency of the green color laser light due to diffusion can be prevented. Furthermore, in order to secure a predetermined margin for optical axis adjustment (approximately 0.3 mm, for example) of the red color laser light source apparatus 3, a space G2 having a predetermined width (0.3 mm or more, for example) is provided between the green color laser light source apparatus 2 and the red color laser light source apparatus 3.

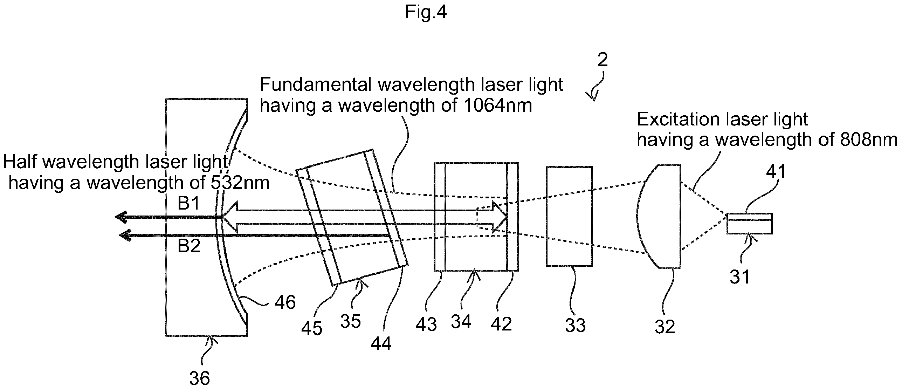

Fig. 4 is a schematic view illustrating a state of green color laser light in the green color laser light source apparatus 2. A laser chip 41 of the semiconductor laser 31 emits excitation laser light having a wavelength of 808 nm. The FAC lens 32 reduces expansion of a fast axis (direction orthogonal to an optical axis direction and along a paper surface of the drawing) of the laser light. The rod lens 33 reduces expansion of a slow axis (direction orthogonal to a paper surface of the drawing) of the laser light.

The laser medium 34, which is a solid-laser crystal, is excited by the excitation laser light having a wavelength of 808 nm and having passed through the rod lens 33, and emits fundamental wavelength laser light (infrared laser light) having a wavelength of 1,064 nm. The laser medium 34 is an inorganic optically active substance (crystal) formed of, such as Y (yttrium) and VO₄ (vanadate), doped with Nd (neodymium). More specifically, the Y of the base material YVO₄ is substituted and doped with Nd⁺³, which is an element producing fluorescence.

A film 42 is provided to the laser medium 34 on a side opposite to the rod lens 33, the film 42 preventing reflection of the excitation laser light having a wavelength of 808 nm and highly reflecting the fundamental wavelength laser light having a wavelength of 1,064 nm and the half wavelength laser light having a wavelength of 532 nm. A film 43 is provided to the laser medium 34 on a side opposite to the wavelength conversion element 35, the film 43 preventing reflection of the fundamental wavelength laser light having a wavelength of 1,064 nm and the half wavelength laser light having a wavelength of 532 nm.

The wavelength conversion element 35, which is an SHG (Second Harmonics Generation) element, converts a wavelength of the fundamental wavelength laser light (infrared laser light) having a wavelength of 1,064 nm emitted from the laser medium 34, and generates the half wavelength laser light (green color laser light) having a wavelength of 532 nm. The wavelength conversion element 35 has a periodically polarization-reversed configuration, in which a region having reversed polarization and a region having an unreversed polarization are alternately formed on a ferroelectric crystal. The fundamental wavelength laser light enters the wavelength conversion element 35 in a polarization-reversed period direction (arrangement direction of the polarization-reversed region). In addition, as the ferroelectric crystal, MgO-doped lithium niobate crystal may be used.

A film 44 is provided to the wavelength conversion element 3 5 on a side opposite to the laser medium 34, the film 44 preventing reflection of the fundamental wavelength laser light having a wavelength of 1,064 nm and highly reflecting the half wavelength laser light having a wavelength of 532 nm. A film 45 is provided to the wavelength conversion element 35 on a side opposite to the concave mirror 36, the film 45 preventing reflection of the fundamental wavelength laser light having a wavelength of 1,064 nm and the half wavelength laser light having a wavelength of 532 nm.

The concave mirror 36 has a concave surface on a side opposite to the wavelength conversion element 35. The concave surface is provided with a film 46 highly reflecting the fundamental wavelength laser light having a wavelength of 1,064 nm and preventing reflection of the half wavelength laser light having a wavelength of 532 nm. Thereby, the fundamental wavelength laser light having a wavelength of 1,064 nm is resonated and amplified between the film 42 of the laser medium 34 and the film 46 of the concave mirror 36.

The wavelength conversion element 35 converts a portion of the fundamental wavelength laser light having a wavelength of 1,064 nm, entering from the laser element 34, to the half wavelength laser light having a wavelength of 532 nm. A portion of the fundamental wavelength laser light having a wavelength of 1,064 nm which is not converted and is transmitted by the wavelength conversion element 35 is reflected by the concave mirror 36. The reflected fundamental wavelength laser light then re-enters the wavelength conversion element 35 and is converted to the half wavelength laser light having a wavelength of 532 nm. The half wavelength laser light having a wavelength of 532 nm is reflected by the film 44 of the wavelength conversion element 35 and emitted from the wavelength conversion element 35.

A laser light beam B1 enters the wavelength conversion element 35 from the laser medium 34, is converted to a different wavelength at the wavelength conversion element 35, and is emitted from the wavelength conversion element 35. A laser light beam B2 is once reflected by the concave mirror 36, enters the wavelength conversion element 35, is reflected by the film 44, and is emitted from the wavelength conversion element 35. In a state where the laser light beam B1 and the laser light beam B2 interfere, the output is reduced. The wavelength conversion element 35 is thus tilted relative to the optical axis direction to prevent the laser light beams B1 and B2 from interfering with each other by refraction, and thus reduction in output can be prevented.

In order to prevent the excitation laser light having a wavelength of 808 nm and the fundamental wavelength laser light having a wavelength of 1,064 nm from leaking externally, a film not transmissive to these laser lights is provided on the glass cover 37 shown in Fig. 2.

In the previous example, the laser chip 41 of the green color laser light source apparatus 2 emits the excitation laser light having a wavelength of 808 nm, the laser medium 34 emits the fundamental laser light (infrared laser light) having a wavelength of 1,064 nm, and the wavelength conversion element 35 emits the half wavelength laser light (green color laser light) having a wavelength of 532 nm. However, the present invention is not limited to the above configuration. As long as laser light emitted from the green color laser light source apparatus 2 is recognized as having a green color, any laser light having a wavelength range with a peak wavelength between 500 nm and 560 nm, for example, may be emitted. In addition, the green color laser light source apparatus 2 does not need to convert a wavelength of the infrared laser light as described above. Instead, similar to the red color laser light source apparatus 3 and the blue color laser light source apparatus 4, the green color laser light source apparatus 2 may employ a semiconductor laser chip emitting green color laser light.

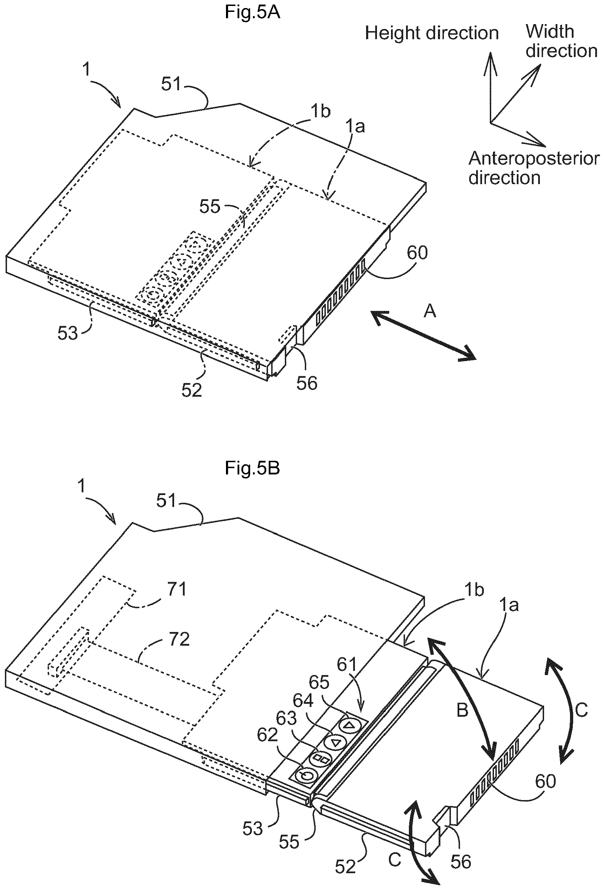

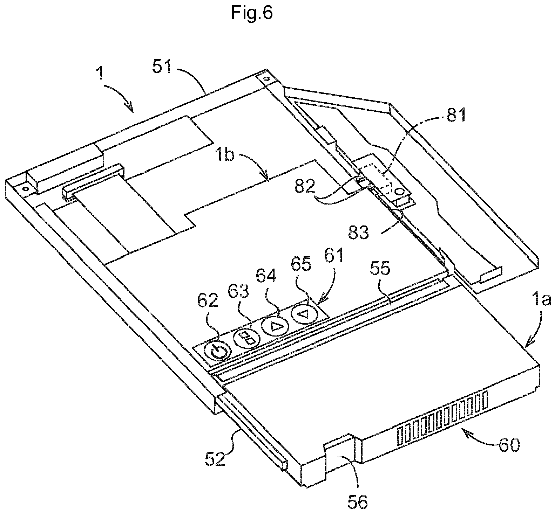

Figs. 5A and 5B are perspective views of the image display apparatus 1. Fig. 6 is a perspective view illustrating an interior of a housing case 51 of the image display apparatus 1. Fig. 5A illustrates a stored state in which the optical engine unit 1a and the control unit 1b are stored in the housing case 51. Fig. 5B illustrates a used state in which the optical engine unit 1a and a portion of the control unit 1b are pulled out from the housing case 51.

Housings of the optical engine unit 1a and the control unit 1b each have a flat box shape having a short height. On two side edges of each of the housings of the optical engine unit 1a and the control unit 1b, sliders 52 and 53 are provided sliding along guide rails (not shown in the drawing) provided inside the housing case 51. Pushing and pulling by a user inserts and removes the entire optical engine unit 1a and a portion of the control unit 1b to and from the housing case 51 as shown with an arrow A.

The optical engine unit 1a and the control unit 1b are connected through a hinge 55, such that the optical engine unit 1a is rotatably supported by the control unit 1b (member on the main body side). An emission window 56 is provided to the optical engine unit 1a at an end opposite to the hinge 55. The laser light passing through the projection optical system 8 of the optical engine unit 1a (see Fig. 2) is emitted from the emission window 56.

As shown in Fig. 1, the housing case 51 housed in the image display apparatus 1 is open to a side surface of the main body 102 of the information processing apparatus 101, such that the optical engine unit 1a and the control unit 1b are inserted to and removed from the side surface of the main body 102 of the information processing apparatus 101 in a substantially orthogonal direction. The housing case 51 of the image display apparatus 1 is fixed in a housing space of the main body 102 of the information processing apparatus 101. The optical engine unit 1a and a portion of the control unit 1b project to the side of the main body 102 of the information processing apparatus 101 during use. The side surface of the information processing apparatus 101 is placed so as to face the screen S from the front, and thus the emission window 56 in the optical engine unit 1a faces the screen from the front.

The hinge 55 shown in Figs. 5A and 5B has an orthogonal biaxial structure. In the used state shown in Fig. 5B, while the control unit 1b is supported by the guide rails of the housing case 51, the optical engine unit 1a can be completely pulled out from the housing case 51 so as to be rotated in a vertical direction as shown with an arrow B and also around the axis extending in an anteroposterior direction, that is, the insertion/removal direction of the optical engine unit 1a and the control unit 1b, as shown with an arrow C.

An exhaust port 60, which is described in detail later, is provided to a front surface of the optical engine unit 1a, the exhaust port exhausting cooling air for the optical engine unit 1a. An operation section 61 is provided to an upper surface of the control unit 1b. The operation section 61 includes a power button 62, a brightness switch button 63, and two trapezoidal distortion correction buttons 64 and 65. In addition, a latch lock (not shown in the drawings) is provided inside the housing case 51 in order to keep the optical engine unit 1a and the control unit 1b in a stored position.

In the housing case 51 of the image display apparatus 1, an interface 71 is provided to which a power supply line and a signal line are connected, the power supply line supplying power from the information processing apparatus 101 and the signal line transmitting image signals from the information processing apparatus 101. The interface 71 and the control unit 1b are connected by a wiring cable 72. The wiring cable 72 is flexible and thus bends and deforms following the control unit 1b when the optical engine unit 1a and the control unit 1b are inserted to/removed from the housing case 51.

As shown in Fig. 6, a switch 81 is provided so as to contact a side edge of the control unit 1b. A contact 82, which contacts the control unit 1b, moves as the optical engine unit 1a and the control unit 1b are inserted to/removed from the housing case 51. The switch 81 is turned on/off according to the motion of the contact 82. The contact 82 is insertably and removably provided to a body of the switch 81 and is biased by a spring (not shown in the drawings) to a projection direction. An abutting portion 83, which abuts the contact 82, is provided to the control unit 1b along the side edge thereof When the abutting portion 83 moves to a location where the abutting portion 83 fits the contact 82, the contact 82 is pushed in by the abutting portion 83. In this embodiment, the switch 81 is in an ON state when neither of two contacts 82 are pushed in, while the switch 81 is in an OFF state when both of two contacts 82 are pushed in.

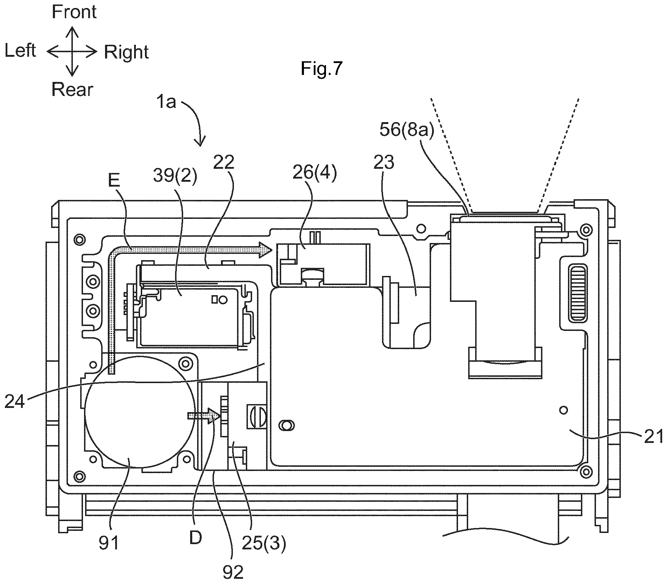

Fig. 7 is a plan view illustrating an interior of a housing of the optical engine unit 1a. A cooling fan 91 is provided inside the housing of the optical engine unit 1a in order to cool the laser light source apparatuses of each color 2 to 4. In the plan view, the housing of the optical engine unit 1a has a rectangular space formed by a pair of long sides and a pair of short sides, the pair of long sides extending in a left-right direction and the pair of short sides extending in an anteroposterior direction. A left-right width of the case 21 fits in the long sides, and a front-back width of the case 21 fits in the short sides. The cooling fan 91 is located behind the green color laser light source apparatus 2 and on the left of the red color laser light source apparatus 3, the green color laser light source apparatus 2 protruding to the left from the case 21.

An air inlet port (not shown in the drawings) is provided directly below the cooling fan 91. As shown in Fig. 5B, when the cooling fan 91 is activated in a state where the optical engine unit 1a and the control unit 1b are pulled out, outside air is taken in from the air inlet port. The taken-in air circulates inside the housing of the optical engine unit 1a, and is then exhausted outside from the exhaust port 60. The cooling air at this time is directed to the heat sink 92 provided on the left of the red color laser light source apparatus 3 as shown with an arrow D in Fig. 7. In addition, as shown with an arrow E, the cooling air proceeds along a cooling air path formed between an internal wall of the housing of the optical engine unit 1a and an external wall of the case 21. The cooling air moves to the mounting plate 22 of the green color laser light source apparatus 2 acting as a heat sink, and then reaches the holder 26 of the blue color laser light source apparatus 4 acting as a heat sink.

As described above, with the cooling fan 91 being provided inside the housing of the rotatable optical engine unit 1a, it is possible to obtain a highly cooling effect on an optical system that generates a great amount of heat when the image display apparatus 1 is operated. The cooling fan 91 is placed in a vicinity of the red color laser light source apparatus 3 on the side wall 24 side of the case 21. Therefore, there is an advantage that the red color laser light source apparatus 3 having inferior temperature characteristics can be given priority in cooling with respect to the other laser light source apparatuses 2 and 4. In addition, since the cooling air flows in the cooling air passage formed by the exterior wall of the case 21, it is also effective in cooling the case 21 (that is, cooling the laser light source apparatuses of each color 2 to 4 via the case 21.)

In the plan views in Figs. 1 and 7, the projection outlet 8a is provided on a right end side of the front wall 23 (that is, the end that is not connected to the side wall 24). In addition, the red color laser light source apparatus 3 is provided on a rear end side of the side wall 24 (that is, the end that is not connected to the front wall 23). Therefore, image light projected from the projection outlet 8a is not blocked by the cooling fan 91 and the heat sink 92. In addition, it is possible to prevent the optical engine unit 1 a from increasing in size.

The cooling fan 91 is provided in an open space behind the green color laser light source apparatus 2 protruding to the left from the case 21. The space inside the housing of the optical engine unit 1a can thus be effectively utilized, and thereby the apparatus can be downsized.

Further, when a semiconductor laser chip similar to that of the red color laser light source apparatus 3 and the blue color laser light source apparatus 4 is employed as the green color laser light source apparatus 2, the green color laser light source apparatus 2 protrudes from the case 21 to the left to an extent similar to the red color laser light source apparatus 3. Thus, it is possible to place the cooling fan 91 on the outer side (left side) of the green color laser light source apparatus 2.

### [Second embodiment]

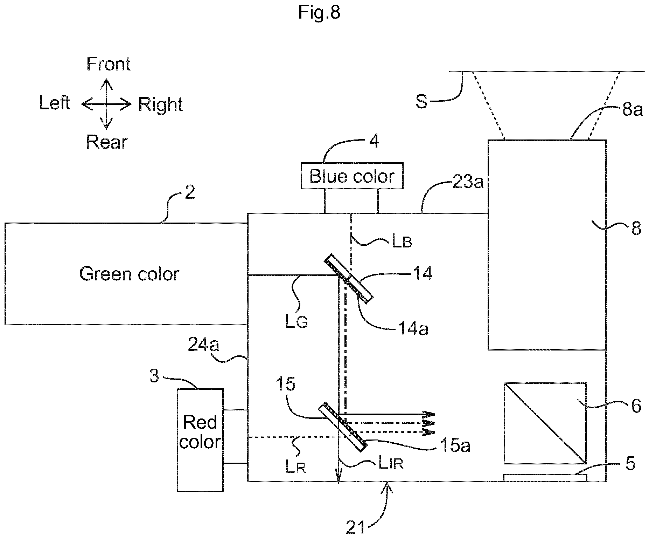

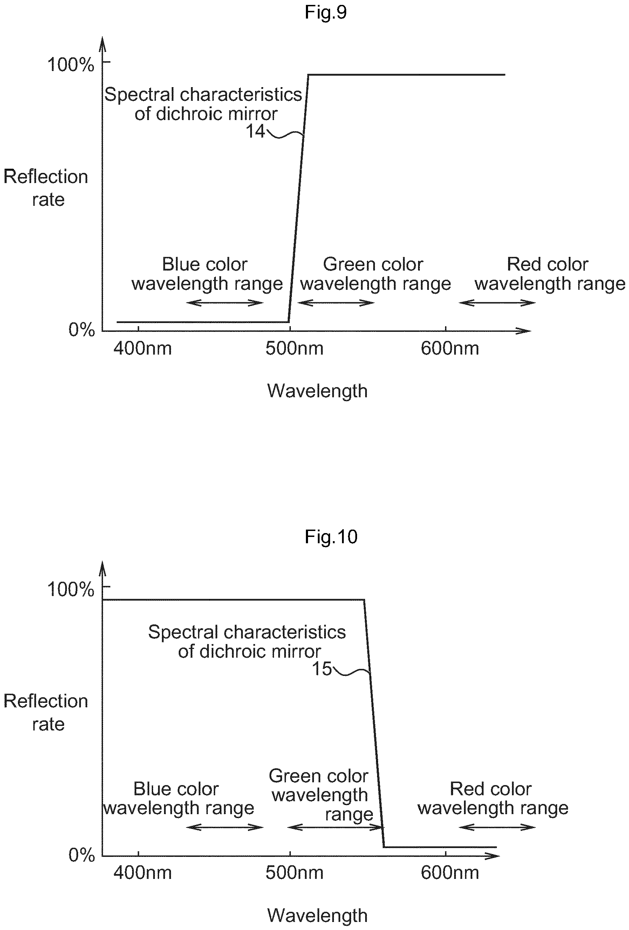

Fig. 8 is a schematic view illustrating optical paths of the laser light of each color in the image display apparatus 1. Figs. 9 and 10 are charts each illustrating spectral characteristics of the first dichroic mirror 14 and the second dichroic mirror 15, respectively. For convenience of description, in Fig. 8, the optical paths of the laser light having respective colors are shown so as not to overlap one another. In practice, however, the optical paths of the laser light having respective colors become the same after converging at the first and the second dichroic mirrors 14 and 15.

As shown in Fig. 8, when a side on which the laser light is emitted from the projection outlet 8a of the projection optical system 8 toward the screen S is a front side, blue color laser light LB is emitted rearward from the blue color laser light source apparatus 4 to the interior of the case 21. As shown in Fig. 2, the laser light source apparatuses of three colors 2 to 4 are placed in a descending order (red color, green color, and blue color) of wavelength of the emitted laser light, as viewed from the projection optical system 8 side (downstream side of the optical paths). An emission optical axis PB of the blue color laser light extends rearward from the blue color laser light source apparatus 4 and sequentially and orthogonally intersects with an emission optical axis PG of the green color laser light and an emission optical axis PR of the red color laser light, the emission optical axis PG and the emission optical axis PR being parallel to each other.

Green color laser light LG is emitted from the green color laser light source apparatus 2 to the interior of the case 21. As also shown in Fig. 8, the first dichroic mirror 14 is provided in a position where the green color laser light LG and the blue color laser light LB intersect (that is, a position where the emission optical axis PG and the emission optical axis PB intersect in Fig. 2). In a plan view, the first dichroic mirror 14 is tilted at 45° relative to a direction (that is, left-right direction) of the emission optical axis PG of the green color laser light shown in Fig. 1. The first dichroic mirror 14 in Fig. 8 transmits the blue color laser light LB and perpendicularly reflects the green color laser light LG toward the second dichroic mirror 15.

The first dichroic mirror 14 has a multi-layer film 14a on a surface (side from which the green color laser light LG enters, in this embodiment) of a base material such as optical glass and the like, the multi-layer film 14a configuring a coated surface of high reflection. A dielectric material, such as TiO₂ ZnO₂ and the like, configuring a thin film of high refractive index and a dielectric material, such as SiO₂ and the like, configuring a thin film of low refractive index are laminated on the base material by vapor deposition or the like, thereby configuring the multi-layer film. As shown in Fig. 9, the first dichroic mirror 14 has spectral characteristics that reflect only light having a wavelength longer than or equal to a green color wavelength range including a green color laser light wavelength. The green color wavelength range is between 500 and 560 nm in this example, but it is not necessarily limited to this range. Such spectral characteristics (reflection wavelength range) of the first dichroic mirror 14 can be appropriately set with an adjustment of the dielectric material configuring the thin film and the thickness of the thin film.

As shown in Fig. 8, red color laser light LR emitted from the red color laser light source apparatus 3 to the interior of the case 21 intersects with the blue color laser light LB having been transmitted by the first dichroic mirror 14 and the green color laser light LG having been reflected by the first dichroic mirror 14. At the intersection (that is, the position where the emission optical axis PR and the emission optical axis PB intersect in Fig.2), the second dichroic mirror 15 is provided. The second dichroic mirror 15 is tilted at 45° relative to a direction (that is, left-right direction) of the emission optical axis PR of the red color laser light. The second dichroic mirror 15 transmits the red color laser light LR and vertically reflects the blue color laser light LB and the green color laser light LG toward the polarization beam splitter 6 and the spatial light modulator 5 (projection optical system 8 side).

The second dichroic mirror 15 has substantially the same configuration as that of the first dichroic mirror 14. A multi-layer film 15a is provided to the dichroic mirror 15 on the side from which the blue color laser light LB and the green color laser light LG enter. As shown in Fig. 10, the second dichroic mirror 15 has spectral characteristics that reflect only light having a wavelength shorter than or equal to the green color wavelength range including the green color laser light wavelength.

The image display apparatus 1 having such a configuration can guide the laser light of each color to the projection optical system 8 side with the two dichroic mirrors 14 and 15, one less in number than the laser light source apparatuses of each color 2 to 4. As a result, the image display apparatus 1 can be smaller and lighter. In particular, the image display apparatus 1 is suitable as an apparatus incorporated in an information processing apparatus (laptop computer and the like, for example).

When the image display apparatus 1 uses the infrared laser light as described above to generate the green color laser light, there is a case where a small amount of infrared rays is emitted from the green color laser light source apparatus 2. However, infrared ray LIR emitted from the green color laser light source apparatus 2 has a wavelength longer than that of a red color visible light ray. Thus, as shown in Fig. 8, the infrared ray LIR is reflected by the first dichroic mirror 14 along with the green color laser light LG but is transmitted by the second dichroic mirror 15, thereby deviating from the optical path. Therefore, the infrared ray LIR is not guided to the polarization beam splitter 6 and the spatial light modulator 5 (projection optical system 8 side). As described above, with at least one of the dichroic mirrors 14 and 15 being configured to reflect the green color laser light LG and also to transmit the infrared ray LIR, the infrared ray LIR is prevented from being projected from the image display apparatus 1 to the exterior. Further, with the configuration shown in Fig. 8, even in a rare case where the second dichroic mirror 15 breaks or drops off, the infrared ray LIR is directed to the rear wall of the case 21 similar to the above case where the infrared ray LIR is transmitted by the second dichroic mirror 15. Therefore, there is an advantage that the infrared ray LIR is not projected from the image display apparatus 1 to the exterior.

In the second embodiment, the second dichroic mirror 15 guides to the right, which is the projection optical system 8 side, the laser light of respective colors LR, LG, and LB entering from the front or the left. However, the laser light of respective colors LR, LG, and LB may also be guided rearward, for example. In this case, arrangements of the spatial light modulator 5, the polarization beam splitter 6, and the projection optical system 8 (projection outlet 8a) and the like need to be appropriately modified according to the optical paths of the laser light having respective colors LR, LG, and LB. In addition, the second dichroic mirror 15 needs to have spectral characteristics that reflect only light having a wavelength longer than or equal to a red color wavelength range including a red color laser light wavelength. The optical paths and the like of the laser light of respective colors entering the dichroic mirrors 14 and 15 are not limited to the configuration described above, and may be modified within the scope of the present invention.

### [Third embodiment]

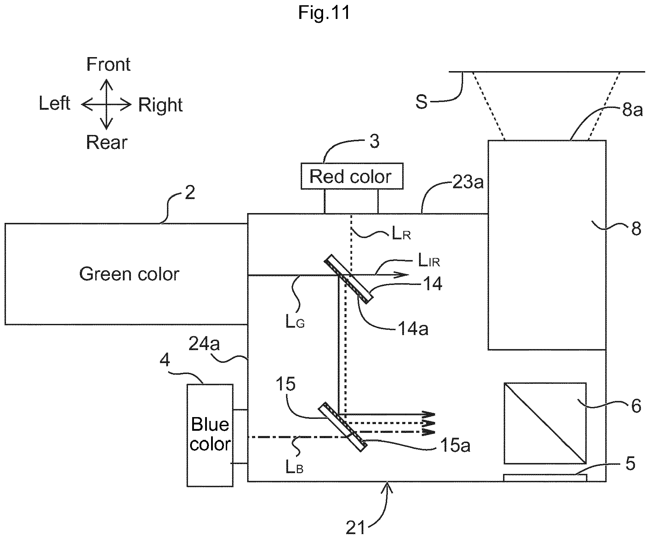

Fig. 11 is a schematic view illustrating optical paths of laser light having respective colors in an image display apparatus 1 according to a third embodiment of the present invention. In Fig. 11, components similar to the second embodiment are provided with the same numerical references. The third embodiment is the same as the above-described second embodiment except what will be specifically described in the following. Detailed description of the third embodiment is thus omitted.

As shown in Fig. 11, in the image display apparatus 1 of the third embodiment, the placements of the red color laser light source apparatus (second laser light source apparatus) 3 emitting the red color laser light (second color laser light) and the blue color laser light source apparatus (first laser light source apparatus) 4 emitting the blue color laser light (first color laser light) are mutually reversed with respect to their placements in the second embodiment. In other words, the laser light source apparatuses of three colors 2 to 4 are arranged in an ascending order (blue color, red color, and green color) of wavelength of the emitted laser light, as viewed from the projection optical system 8 side (downstream side of the optical paths). The first dichroic mirror 14 has spectral characteristics similar to the second dichroic mirror 15 of the second embodiment shown in Fig. 10, and reflects only light having a wavelength shorter than or equal to the green color wavelength range including the green color laser light wavelength. The second dichroic mirror 15 has spectral characteristics similar to the first dichroic mirror 14 of the second embodiment shown in Fig. 9, and reflects only light having a wavelength longer than or equal to the green color wavelength range including the green color laser light wavelength. With such a configuration, even when the red color laser light source apparatus 3 and the blue color laser light source apparatus 4 are placed in a reverse manner, the laser light of respective colors can be guided to the projection optical system 8 side by two dichroic mirrors 14 and 15 in a similar manner to the second embodiment.

Further, in a case where the infrared laser light is used to generate the green color laser light, the infrared ray LIR emitted from the green color laser light source apparatus 2 is transmitted by the first dichroic mirror 14 and deviates from the optical path as shown in Fig. 11, and thus cannot be guided to the second dichroic mirror 15 (projection optical system 8 side). Accordingly, the infrared ray LIR is prevented from being projected from the image display apparatus 1 to the exterior. In addition, with the configuration shown in Fig. 11, even in a rare case where the first dichroic mirror 14 breaks or drops off, the infrared ray LIR is directed to the side wall of the case 21 similar to the above case where the infrared ray LIR is transmitted by the first dichroic mirror 14, thereby providing an advantage that the infrared ray LIR is not projected to the exterior from the image display apparatus 1.

It is noted that the foregoing examples have been provided merely for the purpose of explanation and are in no way to be construed as limiting of the present invention. While the present invention has been described with reference to exemplary embodiments, it is understood that the words which have been used herein are words of description and illustration, rather than words of limitation. Changes may be made, within the purview of the appended claims, as presently stated and as amended, without departing from the scope and spirit of the present invention in its aspects. Although the present invention has been described herein with reference to particular structures, materials and embodiments, the present invention is not intended to be limited to the particulars disclosed herein; rather, the present invention extends to all functionally equivalent structures, methods and uses, such as are within the scope of the appended claims.

The present invention is not limited to the above described embodiments, and various variations and modifications may be possible without departing from the scope of the present invention.

## Claims

1. An image display apparatus employing a semiconductor laser as a light source, comprising:
a first laser light source apparatus emitting a first color laser light;
a second laser light source apparatus emitting a second color laser light having a wavelength different from a wavelength of the first color laser light;
a third laser light source apparatus emitting a third color laser light having a wavelength between the wavelength of the first color laser light and the wavelength of the second color laser light;
a projection optical system externally projecting the laser light of respective colors; and
a case supporting the laser light source apparatuses of respective colors and the projection optical system, wherein
the case includes a front wall and a side wall that is connected to the front wall;
on the front wall, either of the first or the second laser light source apparatus is mounted and a projection outlet of the projection optical system is provided; and
on the side wall, the other of the first or the second laser light source apparatus and the third laser light source apparatus are mounted.

2. The image display apparatus according to claim 1, further comprising:
first and second optical elements reflecting at least one of the three laser lights based on the wavelength of the one of the three laser lights and transmitting at least one of the remaining laser lights based on the wavelength of the one of the remaining laser lights, and guiding the laser light to the projection optical system side, wherein
an emission optical axis of the second color laser light sequentially intersects with an emission optical axis of the third color laser light and an emission optical axis of the first color laser light;
the first optical element transmits the second color laser light and reflects the third color laser light toward the second optical element, the first optical element being at a position where the emission optical axis of the second color laser light and the emission optical axis of the third color laser light intersect; and
the second optical element reflects either one of both the second and third color laser lights and the first color laser light and transmits the other laser light, the second optical element being at a position where the emission optical axis of the second color laser light and the emission optical axis of the first color laser light intersect, the second color laser light having been transmitted by the first optical element, and the third color laser light having been reflected by the first optical element.

3. The image display apparatus according to claim 2, wherein the emission optical axis of the first color laser light is parallel to the emission optical axis of the third color laser light, and
the emission optical axis of the second color laser light sequentially and orthogonally intersects with the emission optical axis of the first color laser light and the emission optical axis of the third color laser light.

4. The image display apparatus according to claim 1, wherein the first color laser light is either one of red color laser light and blue color laser light, the second color laser light is the other one of the red color laser light and the blue color laser light, and the third color laser light is green color laser light.

5. The image display apparatus according to claim 1, wherein the third color laser light is the green color laser light obtained by converting a wavelength of infrared laser light.

6. The image display apparatus according to claim 5, further comprising:
first and second optical elements reflecting at least one of the three laser lights based on the wavelength of the one of the three laser lights and transmitting at least one of the remaining laser lights based on the wavelength of the one of the remaining laser lights, and guiding the laser light to the projection optical system side, wherein
the first optical element reflects, to the projection optical system side, the third color laser light having a wavelength within a green color wavelength range or shorter; transmits the second color laser light to the projection optical system side; and transmits the infrared laser light to a direction which is not the projection optical system side, the first optical element being at a position where the emission optical axis of the laser light emitting the second color laser light and the emission optical axis of the laser light emitting the third color laser light intersect.

7. The image display apparatus according to claim 5, further comprising:
first and second optical elements reflecting at least one of the three laser lights based on the wavelength of the one of the three laser lights and transmitting at least one of the remaining laser lights based on the wavelength of the one of the remaining laser lights, and guiding the laser light to the projection optical system side, wherein
the second optical element reflects, to the projection optical system side, the third color laser light and the second color laser light having wavelengths within a green color wavelength range or shorter; transmits the first color laser light to the projection optical system side; and transmits the infrared laser light to a direction which is not the projection optical system side, the second optical element being at a position where the emission optical axis of the laser light emitting the first color laser light and the emission optical axis of the laser light emitting the second color laser light intersect.

8. The image display apparatus according to claim 1, wherein the projection outlet is provided to the front wall at an end that is not connected to the side wall, and
the red color laser light source apparatus is provided to the side wall at an end that is not connected to the front wall.

9. The image display apparatus according to claim 1, further comprising:
a cooler that is provided outside the case and cools the laser light source apparatuses of respective colors, wherein
the cooler is provided on the side wall side.

10. The image display apparatus according to claim 1, further comprising:
a cooler that is provided outside the case and cools the laser light source apparatuses of respective colors, wherein
the cooler is provided on the side wall side in a vicinity of the laser light source apparatus emitting the first color laser light.

11. The image display apparatus according to claim 1, further comprising:
a cooler that is provided outside the case and cools the laser light source apparatuses of respective colors, wherein
the side wall has a projection which protrudes in a direction extended from an end of the front wall and to which the third laser light source apparatus is mounted, and
the cooler is provided outside the other of the first or the second laser light source apparatus.
